(19) Europäisches Patentamt

European Patent Office

Office européen des brevets

(11) **EP 1 135 854 B1**

(12) **EUROPÄISCHE PATENTSCHRIFT**

(45) Veröffentlichungstag und Bekanntmachung des Hinweises auf die Patenterteilung:
**21.05.2003 Patentblatt 2003/21**

(21) Anmeldenummer: **99960870.6**

(22) Anmeldetag: **08.11.1999**

(51) Int Cl.$^7$: **H03H 7/06**

(86) Internationale Anmeldenummer:
**PCT/DE99/03563**

(87) Internationale Veröffentlichungsnummer:
**WO 00/028660 (18.05.2000 Gazette 2000/20)**

(54) **TIEFPASS FÜR EINE ADSL-FREQUENZWEICHE**

LOW PASS FOR AN ADSL DIPLEXER

FILTRE PASSE-BAS POUR DIPLEXEUR LNPA

(84) Benannte Vertragsstaaten:
**DE ES FR GB IT**

(30) Priorität: **10.11.1998 DE 19851872**

(43) Veröffentlichungstag der Anmeldung:
**26.09.2001 Patentblatt 2001/39**

(73) Patentinhaber: **Vacuumschmelze GmbH
63450 Hanau (DE)**

(72) Erfinder: **HEUMANN, Dirk
D-61130 Nidderau (DE)**

(74) Vertreter: **Schmuckermaier, Bernhard
PAe Westphal, Mussgnug & Partner,
Mozartstrasse 8
80336 München (DE)**

(56) Entgegenhaltungen:
**EP-A- 0 063 414        EP-A- 0 677 938**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

## Beschreibung

Die Erfindung betrifft eine Filteranordnung mit jeweils paarweise angeordneten, sich zwischen Polen der Filteranordnung erstreckenden und Induktivitäten aufweisenden Längszweigen und mit wenigstens einem sich zwischen den Längszweigen erstreckenden, wenigstens eine Kapazität aufweisenden Querzweig.

Derartige Filteranordnungen sind aus dem Handbuch Anatol I. Zverev, "Handbook of Filter Synthesis", 1967, oder aus EP-A-0 063 414, bekannt. Die bekannten Filteranordnungen lassen sich zu Frequenzweichen zusammensetzen. Wenn beispielsweise ein Tiefpaß und ein Hochpaß parallel geschaltet sind, werden hochfrequente Signale über den mit einem Hochpaß versehenen Filterzweig und niederfrequente Signale über den mit einem Tiefpaß ausgestatteten Filterzweig geleitet. Im ADSL-Telekommunikationssystem erfolgt nun die Verbindung zwischen einer ADSL-fähigen digitalen Ortsvermittlungsstelle und dem ADSL-Modem, das gleich dem teilnehmerseitigen Netzabschluß ist, über eine öffentliche Zweidrahtleitung. ADSL steht dabei für "Asymmetric Digital Subscriber Line". Zeitgleich können über dieselbe Zweidrahtleitung POTS- und ISDN-Verbindungen laufen. POTS steht dabei für "Plain Old Telefone System" und ISDN für "Integrated Services Digital Network". Die Trennung und Übertragung der niederfrequenten POTS- oder ISDN-Komponenten von den ADSL-Komponenten wird durch Filterweichen bewirkt, die an den Enden der öffentlichen Zweidrahtleitungen sitzen. Die niederfrequenten POTS- oder ISDN-Komponenten werden dabei über einen Tiefpaß in einen Tiefpaßzweig gelenkt, während die hochfrequenten ADSL-Komponenten über einen Hochpaß in einen Hochpaßzweig geführt werden. Ein für den Einsatz in einer ADSL-Filterweiche geeigneter Tiefpaß muß bestimmten Anforderungen bezüglich der Übertragungsfunktion, der Gruppenlaufzeitverzerrung und der Reflexionsdämpfung genügen. Im Durchlaßbereich wird insbesondere eine möglichst hohe Reflexionsdämpfung angestrebt. Beispielsweise soll die Reflexionsdämpfung im POTS-Durchlaßbereich von 200 Hz bis 4 kHz > 18 dB betragen sowie bei 16 kHz > 14 dB sein. Die bekannten Filter genügen diesen Anforderungen nicht.

Ausgehend von diesem Stand der Technik liegt der Erfindung die Aufgabe zugrunde, eine Filteranordnung mit verbesserter Reflexionsdämpfung zu schaffen, die auch die Anforderungen bezüglich der Übertragungsfunktion und der Gruppenlaufzeitverzerrung erfüllt.

Diese Aufgabe wird erfindungsgemäß dadurch gelöst, daß die Induktivitäten in den Längszweigen in Filterbaugruppen angeordnet sind, die jeweils in Reihe geschaltete Induktivitäten mit einem parallel zu einer der Induktivitäten geschalteten reellen Widerstand umfassen.

Dadurch daß die Induktivitäten in Längszweigen in Filterbaugruppen angeordnet sind, die jeweils einen zu einer der Induktivitäten parallel geschalteten reellen Widerstand aufweisen, läßt sich der Abschlußwiderstand der Filteranordnung an einen komplexen Leitungswiderstand anpassen, so daß sich für die Filteranordnung eine hohe Reflexionsdämpfung im Arbeitsbereich ergibt.

Weitere Ausgestaltungen und vorteilhafte Ausführungsformen sind in den abhängigen Ansprüchen angegeben.

Nachfolgend wird die Erfindung anhand der beigefügten Zeichnung näher beschrieben. Es zeigen:

Figur 1      eine Übersicht über die Verbindung zwischen einer Ortsvermittlungsstelle und einem teilnehmerseitigen Netzabschluß;

Figur 2      eine herkömmliche aus Induktivitäten und Kapazitäten zusammengesetzte Tiefpaßfilteranordnung;

Figur 3      ein Ersatzschaltbild für den komplexen Leitungswiderstand der öffentlichen Zweidrahtleitung;

Figur 4      eine Darstellung der zur Umwandlung des herkömmlichen Tiefpaßfilters aus Figur 2 notwendigen Transformation; und

Figur 5      ein Ausführungsbeispiel eine Tiefpaßfilters, das an den komplexen Leitungswiderstand aus Figur 3 angepaßt ist.

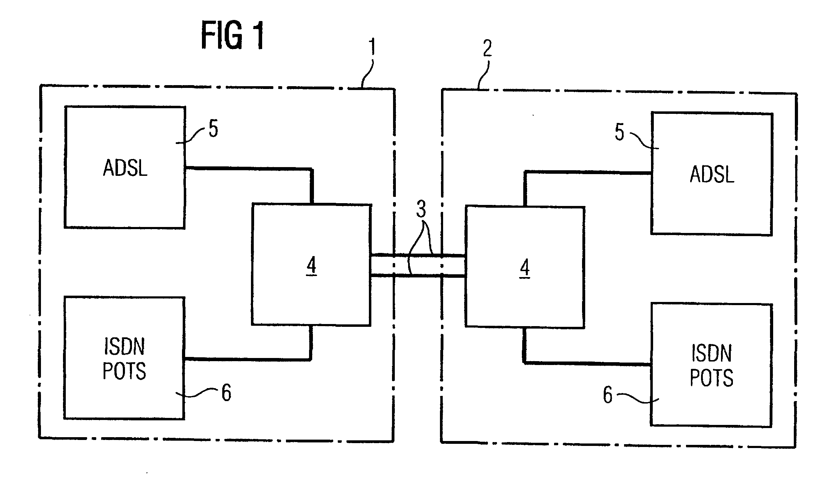

Figur 1 zeigt eine schematische Darstellung der Verbindung zwischen einer Ortsvermittlungsstelle 1 und einem teilnehmerseitigen Netzabschluß 2, die über eine öffentliche Zweidrahtleitung 3 untereinander verbunden sind. Am Ende der Zweidrahtleitung 3 sind Frequenzweichen 4 vorgesehen. Die über die öffentliche Zweidrahtleitung 3 laufenden hochfrequenten ADSL-Signale werden von den Frequenzweichen 4 in einen ADSL-Zweig 5 gelenkt, während die niederfrequenten POTS- und ISDN-Signale von den Frequenzweichen 4 jeweils in einen POTS-/ISDN-Zweig 6 gelenkt werden. Am Eingang des POTS-/ISDN-Zweigs 6 ist zweckmäßigerweise ein Tiefpaßfilter angeordnet.

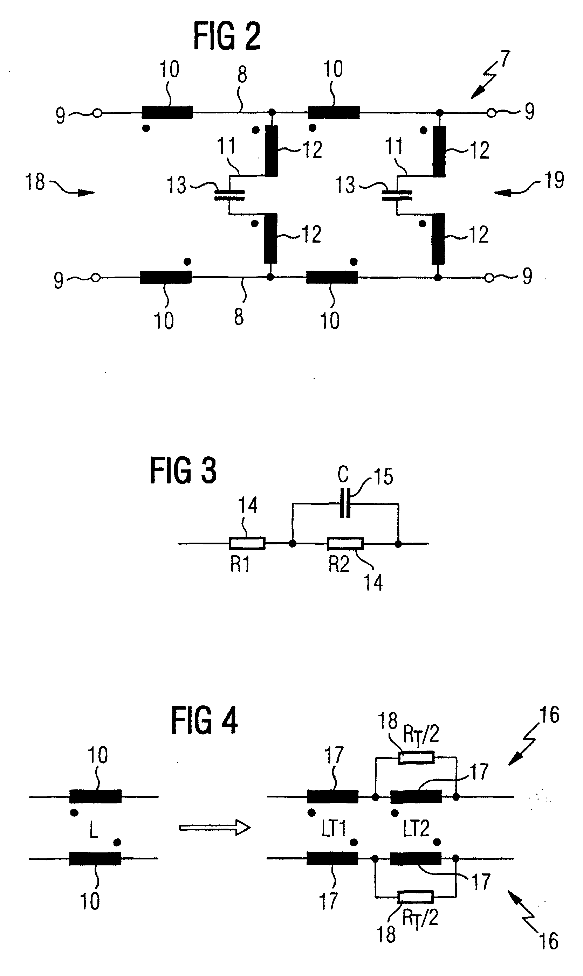

Figur 2 zeigt ein für den Einsatz im POTS-/ISDN-Zweig 6 bedingt geeignetes Tiefpaßfilter, das auf einen reellen Abschlußwiderstand ausgelegt ist. Das Tiefpaßfilter 7 aus Figur 2 ist ein symmetrisches Filter vierter Ordnung und weist paarweise angeordnete Längszweige 8 auf, die sich zwischen Polen 9 des Tiefpaßfilters 7 erstrecken. In den Längszweigen 8 sind Längsinduktivitäten 10 angeordnet. Jeweils zwei der in dem Schaltbild in Figur 2 gegenüberliegenden Induktivitäten werden dabei von auf einen gemeinsamen Magnetkern mit gleichem Wicklungssinn aufgewickelten Spulen gebildet. Zwischen den Längszweigen 8 sind Querzweige 11 angeordnet, die jeweils zwei Querinduktivitäten 12 und eine zwischen den Querinduktivitäten 12 angeordnete Kapazität 13 aufweist. Die jeweils in einem Querzweig 11 vorhandenen Querinduktivitäten 12 sind von auf einen gemeinsamen Magnetkern im gleichen Wicklungssinn aufgewickelten Spulen gebildet. Durch die in den Querzweigen 11 vorhandene Kombination der Kapazität 13 und der Querinduktivitäten 12 werden Nullstellen der Übertragungsfunktion gebildet und der Abfall der Übertragungsfunktion oberhalb einer Grenzfrequenz verstärkt.

Das in Figur 2 dargestellte Tiefpaßfilter 7 ist auf einen reellen Abschlußwiderstand ausgelegt und vermag deshalb strengen Anforderungen an die Reflexionsdämpfung bei einem komplexen Leitungswiderstand nicht zu genügen.

Der Leitungswiderstand der öffentlichen Zweidrahtleitung 3 ist in Figur 3 für den Grenzfall kleiner Frequenzen durch ein Ersatzschaltbild veranschaulicht. Der Abschlußwiderstand kann durch ohmsche Widerstände mit den Werten R1 und R2 dargestellt werden, wobei eine Kapazität mit dem Wert C parallel zum ohmschen Widerstand 14 mit dem Wert R2 geschaltet ist. Im folgenden soll für den komplexen Abschlußwiderstand der öffentlichen Zweidrahtleitung 3 gelten:

$$Z = R1 + R2 \parallel \frac{1}{i\omega C} \tag{1}$$

Um nun das auf einen reellen Abschlußwiderstand R ausgelegte Tiefpaßfilter 7 in ein Tiefpaßfilter umzuwandeln, das an den komplexen Abschlußwiderstand der Zweidrahtleitung 3 angepaßt ist, ist es erforderlich, wie in Figur 4 dargestellt, die Induktivitäten 10 im Längskreis 8 durch Baugruppen 16 zu ersetzen, die jeweils über zwei Teilinduktivitäten 16 und einem zu einem der Teilinduktivitäten 16 parallel geschalteten reellen Teilwiderstand 17 verfügen.

Die vorgenommene Umwandlung läßt sich wie folgt begründen:

Betrachtet sei der Tiefpaßfilter 7 aus Figur 2, der einen reellen Wellenwiderstand

$$R = \sqrt{Z_O \cdot Z_G} \tag{2}$$

aufweist, wobei $Z_O$ die Impedanz des Tiefpaßfilters 7 mit offenem Ende und $Z_G$ die Impedanz des Tiefpaßfilters 7 bei kurzgeschlossenem Ende ist. Um nun das Tiefpaßfilter 7 auf den komplexen Abschlußwiderstand passiv zu transformieren, wird Gleichung (2) mit dem Faktor Z/R multipliziert. Es ergibt sich dann der Ausdruck:

$$Z = \sqrt{\frac{Z}{R} \cdot Z_O \cdot \frac{Z}{R} \cdot Z_G} \tag{3}$$

Bei einer beliebigen vierpoligen Filteranordnung nach Figur 2 ergibt sich beispielsweise die Impedanz $Z_O$ als Gesamtimpedanz zwischen den einen Eingang 18 bildenden Polen 9 bei offenen einen Ausgang 19 bildenden Polen 9. Die Gesamtimpedanz $Z_O$ ergibt sich dann bei Serienschaltung als eine Summe von Impedanzwerten oder bei Parallelschaltung als das Inverse der Summe von invertierten Impedanzwerten. Das gleiche gilt für die Berechnung der Gesamtimpedanz $Z_G$, die sich als die Impedanz zwischen den eingangsseitigen Polen 9 bei kurzgeschlossenen ausgangsseitigen Polen 9 ergibt. Nach dem Distributivgesetz kann der Transformationsfaktor Z/R in die Summen hineingezogen werden, so daß sich die Transformation des gesamten Tiefpaßfilters 7 auf eine Transformation der einzelnen das Tiefpaßfilter 7 bildenden Impedanzen reduziert. Für die Induktivitäten mit dem Wert L ergibt sich dann eine transformierte Impedanz

$$Z_{Trafo}(i\omega L) = \left( R1 + R2 \parallel \frac{1}{i\omega C} \right) \frac{i\omega L}{R} \tag{4}$$

Dieser Ausdruck läßt sich umformen zu

$$Z_{Trafo}(i\omega L) = i\omega L_{T_1} + i\omega L_{T_2} \| R_T \tag{5}$$

mit

$$L_{T_1} = \frac{R1}{R} \cdot L \tag{6}$$

$$L_{T_2} = \frac{R2}{R} \cdot L \tag{7}$$

$$R_T = \frac{L}{CR} \tag{8}$$

Berücksichtigt man, daß in dem Tiefpaßfilter 7 aus Figur 2 gegenüberliegende Induktivitäten von auf einem gemeinsamen Magnetkern mit gleichem Wicklungssinn Drosseln gebildet sind, ergibt sich schließlich die in Figur 4 dargestellte Transformation. Man beachte, daß die Längsinduktivitäten 10 nicht unabhängig sind, sondern daß es sich dabei um auf einen gemeinsamen Magnetkern gewickelte Spulen handelt, die gemeinsam den Induktivitätswert L aufweisen. In gleicher Weise handelt es sich bei gegenüberliegenden Teilinduktivitäten 17 um auf einen gemeinsamen Magnetkern gewickelte Spulen die zusammen den Wert $L_{T_1}$ und $L_{T_2}$ aufweisen.

Für eine gute Reflexionsdämpfung reicht es aus wenn die Induktivitäten 10 in den Längszweigen 8 transformiert werden. Die Reflexionsdämpfung läßt sich jedoch dadurch weiterverbessern, wenn auch die Induktivitäten 12 in den Querzweigen 11 der in Figur 4 dargestellten Transformation unterzogen werden.

Die Kapazitäten 13 in den Querzweigen 11 können nicht mit Z/R transformiert werden, da die entstehenden Impedanzfunktion keine Zweipolfunktion sind, denn die sich ergebenden Impedanzfunktion weisen in der rechten Halbbebene der komplexen S-Ebene Nullstellen auf. Somit kann die sich ergebende Impedanzfunktion nicht in Einzelkomponenten zerlegt werden. Die Kapazitäten 13 in den Querzweigen 11 spielen für die Reflexionsdämpfung nur im sehr niederfrequenten Bereich eine Rolle, da sie für hohe Frequenzen durchlässig sind. Liegen die Werte für die Kapazitäten 13 unterhalb eines Maximalwertes, müssen sie nicht berücksichtigt werden. Insofern reicht es aus, nur die Induktivitäten zu transformieren.

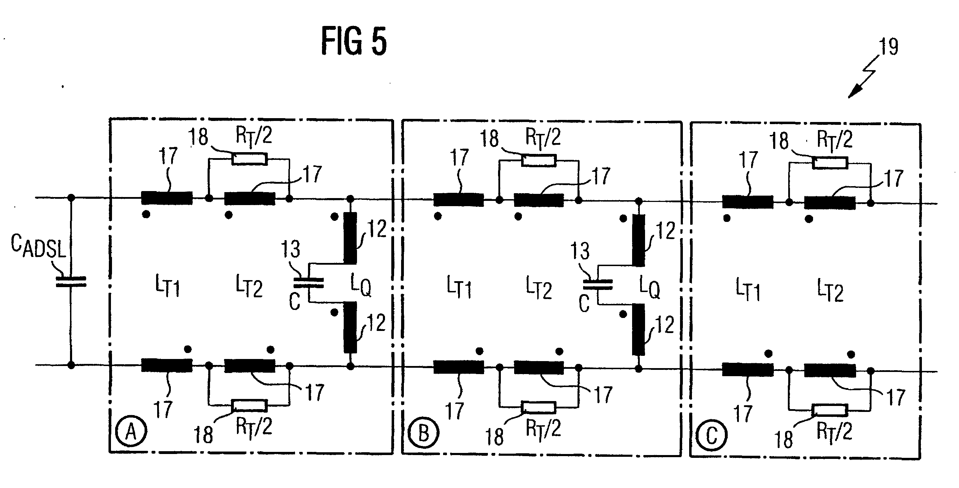

Ein nur im Längszweig 8 transformierter Tiefpaß 19 hat dann das in Figur 5 dargestellte Aussehen. Bei dem in Figur 5 dargestellten Ausführungsbeispiel eines an einen komplexen Abschlußwiderstand angepaßten Filters 19 handelt es sich um ein Filter 6. Ordnung mit drei Filterstufen A, B und C. Durch die Kapazität $C_{ADSL}$ wird der zum ADSL-Zweig 5 führende Hochpaß dargestellt. Mögliche Zahlenwerte, um das Tiefpaßfilter 19 an einen komplexen Abschlußwiderstand mit R1 = 220 Ω, R2 = 820 Ω und C = 125 nF anzupassen, sind in Tabelle 1 angegeben.

Tabelle 1:

| Bauelement | Stufe | Wert |
|---|---|---|
| $C_{ADSL}$ | | 6, 8 nF |
| $L_{T_1}$ | A | 697 µH |
| $L_{T_2}$ | A | 2598 µH |
| $R_{T_1}$ | A | 27,5 Ω |
| $L_Q$ | A | 72 µH |
| C | A | 11,7 nF |
| $L_{T_1}$ | B | 798 µH |
| $L_{T_2}$ | B | 2974 µH |
| $R_T$ | B | 31,5 Ω |
| $L_Q$ | B | 41 µH |
| C | B | 10,5 nF |
| $L_{T_1}$ | C | 421 µH |
| $L_{T_2}$ | C | 1569 µH |

Tabelle 1: (fortgesetzt)

| Bauelement | Stufe | Wert |
|---|---|---|
| $R_T$ | C | 16,6 Ω |

Es sei anmerkt, daß die Werte der einzelnen Längsinduktivitäten 17 jeweils gleich $L_{T1}/4$ oder $L_{T2}/4$ betragen. In gleicher Weise sind die Werte der einzelnen Querinduktivitäten 12 gleich $L_Q/4$.

**Patentansprüche**

1. Filteranordnung mit jeweils paarweise angeordneten, sich zwischen Polen (9) der Filteranordnung erstreckenden und Induktivitäten (17) aufweisenden Längszweigen (8) und mit wenigstens einem sich zwischen den Längszweigen (8) erstreckenden, wenigstens eine Kapazität (13) aufweisenden Querzweig (11),
**dadurch gekennzeichnet,**
**daß** die Induktivitäten (17) in den Längszweigen (8) in Filterbaugruppen (16) angeordnet sind, die jeweils in Reihe geschaltete Induktivitäten (17) mit einem parallel zu einer der Induktivitäten (17) geschalteten reellen Widerstand (18) umfassen.

2. Filteranordnung nach Anspruch 1,
**dadurch gekennzeichnet,**
**daß** bei den paarweise vorhandenen Längszweigen (8) die Anordnung der Filterbaugruppen (16) übereinstimmt.

3. Filteranordnung nach Anspruch 2,
**dadurch gekennzeichnet,**
**daß** die Längszweige (8) von in Reihe geschalteten Filterbaugruppen (16) gebildet sind, hinter denen jeweils ein Querzweig (11) angeordnet ist.

4. Filteranordnung nach Anspruch 3,
**dadurch gekennzeichnet,**
**daß** jeder Querzweig (11) von einer Reihenschaltung von Induktivitäten (12) und Kapazitäten (13) gebildet ist.

5. Filteranordnung nach Anspruch 4,
**dadurch gekennzeichnet,**
**daß** jeder Querzweig (11) von zwei Induktivitäten (12) gebildet ist, zwischen denen eine Kapazität (13) angeordnet ist.

6. Filteranordnung nach einem der Ansprüche 2 bis 5,
**dadurch gekennzeichnet,**
**daß** sich entsprechende Induktivitäten (17) im Längszweig (8) von auf einen gemeinsamen Magnetkern gewickelten Wicklungen gebildet sind.

7. Filteranordnung nach Anspruch 5 oder 6,
**dadurch gekennzeichnet,**
**daß** die Induktivitäten (12) im Querzweig (11) von auf einen gemeinsamen Magnetkern gewickelten Wicklungen gebildet sind.

**Claims**

1. Filter arrangement with series arms (8) arranged in pairs, extending between poles (9) of the filter arrangement and comprising inductors (17), and at least one shunt arm (11) extending between the series arms (8) and comprising at least one capacitor (13), **characterised in that** the inductors (17) in the series arms (8) are arranged in filter modules (16) each including series inductors (17) with an ohmic resistor (18) connected in parallel with one of the inductors (17).

2. Filter arrangement according to claim 1, **characterised in that** the arrangement of the filter modules (16) conforms with the series arms (8) arranged in pairs.

3. Filter arrangement according to claim 2, **characterised in that** the series arms (8) are formed by series-connected filter modules (16) downstream of which respective shunt arms (11) are arranged.

4. Filter arrangement according to claim 3, **characterised in that** each shunt arm (11) is formed by the series connection of inductors (12) and capacitors (13).

5. Filter arrangement according to claim 4, **characterised in that** each shunt arm (11) is formed by two inductors (12) between which a capacitor (13) is arranged.

6. Filter arrangement according to one of claims 2 to 5, **characterised in that** corresponding inductors (17) in the series arm (8) are formed by windings wound on to a common magnetic core.

7. Filter arrangement according to claim 5 or claim 6, **characterised in that** the inductors (12) in the shunt arm (11) are formed by windings wound on to a common magnetic core.


**Revendications**

1. Dispositif de filtre ayant chaque fois des branches longitudinales (8) reliant les pôles (9) du dispositif de filtre et comportant des inductances (17) et au moins une branche transversale (11) s'étendant entre les branches longitudinales (8) et ayant au moins une capacité (13),
   **caractérisé en ce que**
   les inductances (17) des branches longitudinales (8) sont des groupes de filtres (16) ayant chacun des inductances (17) en série avec une résistance réelle (18) branchée en parallèle sur l'une des inductances (17).

2. Dispositif de filtre selon la revendication 1,
   **caractérisé en ce que**
   pour les branches longitudinales 8 existant par paires, la disposition des groupes de filtre (16) se correspondent.

3. Dispositif de filtres selon la revendication 2,
   **caractérisé en ce que**
   les branches longitudinales (8) sont formées par des groupes de filtre (16) branchés en série et derrière lesquels il y a à chaque fois une branche transversale (11).

4. Dispositif selon la revendication 3,
   **caractérisé en ce que**
   chaque branche transversale (11) est formée par le montage en série d'inductances (12) et de capacités (13).

5. Dispositif selon la revendication 4,
   **caractérisé en ce que**
   chaque branche transversale (11) est formée de deux inductances (12) entre lesquelles se trouve une capacité (13).

6. Dispositif selon l'une des revendications 2 à 5,
   **caractérisé en ce que**
   les inductances correspondantes (17) sont formées dans la branche longitudinale (8) par des enroulements réalisés sur un noyau magnétique commun.

7. Dispositif selon la revendication 5 ou 6,
   **caractérisé en ce que**
   les inductances (12) sont formées dans la branche transversale (11) par des enroulements réalisés sur un noyau magnétique commun.

FIG 1

## FIG 2

## FIG 3

## FIG 4

## FIG 5

EP 1 135 854 B1